# EUROPÄISCHE PATENTSCHRIFT

(11) **EP 2 009 501 B1**
(45) Veröffentlichungstag und Bekanntmachung des Hinweises auf die Patenterteilung: **27.02.2013**
(21) Anmeldenummer: 08159027.5
(22) Anmeldetag: 25.06.2008
(51) Int. Cl.: G03F 7/20

(54) **Verfahren und Vorrichtung für die Steuerung einer Vielzahl von Aktuatoren einer Projektionsbelichtungsanlage für die Mikrolithographie**
Method and apparatus for controlling a plurality of actuators of a projection exposure apparatus for microlithography
Procédé et dispositif pour contrôler plusieurs actionneurs d'un appareil d'exposition par projection pour la microlithographie

(30) Priorität: 26.06.2007 DE 102007029638; 26.06.2007 US 946177 P
(43) Veröffentlichungstag der Anmeldung: 31.12.2008
(73) Patentinhaber: Carl Zeiss SMT GmbH, 73447 Oberkochen (DE)
(72) Erfinder: Rohe, Thomas, 72441, Bopfingen (DE); Fischer, Jürgen, 89518, Heidenheim (DE); Bach, Florian, 73447, Oberkochen (DE)
(74) Vertreter: Lang, Christian

(56) Entgegenhaltungen:
- KR-A- 20070 065 849
- US-A- 5 670 977
- US-A1- 2005 024 613

## Beschreibung

Die vorliegende Erfindung betrifft eine Projektionsbelichtungsanlage nach dem Oberbegriff des Anspruchs 1 sowie ein entsprechendes Verfahren nach dem Oberbegriff des Anspruchs 12.

### STAND DER TECHNIK

Für die Herstellung mikroelektronischer Bauteile, wie beispielsweise integrierter Schaltkreise, oder mikromechanischer Systeme sind Lithographiesysteme, bei welchen lichtempfindliche Schichten auf Substraten zur Erzeugung von Strukturen belichtet werden, bekannt. Für derartige Lithographiesysteme werden Vorrichtungen benötigt, die hierin ganz allgemein als Abbildungsvorrichtungen bezeichnet werden sollen, mit denen es möglich ist, kleinste Strukturen auf eine strahlungs- bzw. lichtempfindliche Schicht eines Substrats (Wafer) zu übertragen. Zu derartigen Abbildungsvorrichtungen gehören Projektionsbelichtungsanlagen, bei denen über ein Beleuchtungssystem das Licht einer Lichtquelle, z.B. eines Lasers, auf eine Maske, das so genannte Retikel, geleitet wird, um dieses auszuleuchten. Die Strukturen der Maske bzw. Retikels werden über ein Projektionsobjektiv auf das Substrat mit der lichtempfindlichen Schicht abgebildet. Zur geeigneten Ausleuchtung des Retikels können im Beleuchtungssystem Lichtmodulationseinrichtungen, beispielsweise in Form einer Mehrfachspiegelanordnung (Multi Mirror Array, MMA) eingesetzt werden, um beispielsweise eine bestimmte Intensitätsverteilung des Lichts in einer Pupillenebene des Beleuchtungssystems zu erreichen. Eine derartige Projektionsbelichtungsanlage ist beispielsweise in der DE 103 43 333 A1 beschrieben. Eine ähnliche Projektionsbelichtungsanlage ist auch in der US 7,061,582 B2 beschrieben, bei welcher ebenfalls eine Mehrfachspiegelanordnung eingesetzt wird.

Die US 7,053,987 B2 beschreibt ganz allgemein, räumliche Lichtmodulationseinrichtung, so genannte Spatial Light Modulators SLMs, die in Lithographiesystemen eingesetzt werden, um eine Amplitudenverteilung, eine Phasenverteilung und/oder eine Polarisationsverteilung der Strahlung zu bewirken.

Darüber hinaus ist es aus der EP 914626 bzw. WO 98/04959 bekannt, mit einer Lichtmodulationseinrichtung in Form einer Mehrfachspiegelanordnung ein maskenloses Lithographiesystem zu verwirklichen, bei welchem anstelle der Beleuchtung eines Retikels mit der entsprechenden Mikrostruktur die abzubildende Struktur durch die Stellung der Mikrospiegel einer Mehrfachspiegelanordnung und die dadurch bewirkte Intensitätsverteilung erzeugt wird. Auch dieser Stand der Technik stellt einen Anwendungsfall für die vorliegende Erfindung dar.

Bei all diesen Anwendungsfällen für Lichtmodulationseinrichtungen und insbesondere Mehrfachspiegelanordnungen (MMAs) stellt sich das Problem, dass die Vielzahl von Komponenten der Lichtmodulationseinrichtung, also beispielsweise der Mikrospiegel, entsprechend gesteuert werden muss. Dies ist beispielsweise in der US 2005/0177326 A1 angesprochen, welche sich im Wesentlichen mit der Fehlervermeidung bei hochvolumigen Datenströmen zur Steuerung von SLM-Chips beschäftigt.

Neben der Problematik der Signalqualität bei hohen Datenraten besteht jedoch die weitere Problematik darin, dass aufgrund von hohen Datenraten kurze Schaltzeiten der Spiegel sowie entsprechend schnelle Taktzeiten nicht mehr möglich sind, da dies durch die Datenübertragungszeit begrenzt sind. Nimmt man beispielsweise eine Mehrfachspiegelanordnung mit 40000 Spiegeln mit je vier aktiven Kanälen für eine Einstellung in zwei Freiheitsgraden bei einer Einstellgenauigkeit von 10 Bit, so wäre bei einer Einstellzeit von 1 Millisekunde eine Datenrate von mindestens 160 Megabit pro Sekunde nötig. Diese erforderliche Datenrate würde bei einer Erhöhung der Spiegelanzahl, der Einstellgenauigkeit oder der benötigten Bandbreite für Protokolldaten noch zusätzlich stark ansteigen.

Aus der EP 1801656 A1 ist eine Lithographieapparatur bekannt, bei der sogenannte Strukturierungsvorrichtungen mit einer Vielzahl von einstellbaren Elementen vorgesehen sind. Zur wiederholten Einstellung von bestimmten Mustern der einstellbaren Elemente sind Speicher vorgesehen, die über entsprechende Steuerungseinheiten abgespeicherte Muster abgeben. Damit lässt sich die Steuerung vereinfachen, da bestimmte Strukturierungen wiederholt aus einem entsprechenden Speicher abgerufen werden können. Das Problem der Schaltgeschwindigkeit wird hierbei jedoch nicht gelöst.

Die US 2005/0024613 A1 schlägt zur Erhöhung der Datentransfergeschwindigkeiten das Vorsehen zusätzlicher Schaltungen vor, um die Verarbeitung der Steuersignale zu verbessern.

Die US 5,670,977 offenbart eine räumliche Lichtmodulationseinrichtung (SLM) mit sogenannten Schattenspeicherelementen, die jedem Spiegel eine Mehrfachspiegelanordnung der räumlichen Lichtmodulationseinrichtung zugeordnet sind. Die Schattenspeicher umfassen dabei zwei Speicherplätze, wobei einer der Speicherplätze Steuerdaten zum Steuern des Spiegels abgeben kann, während der andere Speicherplatz zum Zwischenspeichern nachfolgender Steuerdaten genutzt wird. Damit kann die Ladezeit für die Steuerdaten reduziert werden.

### OFFENBARUNG DER ERFINDUNG

### AUFGABE DER ERFINDUNG

Es ist deshalb Aufgabe der vorliegenden Erfindung, eine Vorrichtung und ein Verfahren bereit zu stellen, mit welchen eine Vielzahl von Aktuatoren, beispielsweise für die Betätigung von Komponenten einer Lichtmodulationseinrichtung, insbesondere der Mikrospiegel einer Mehrfachspiegelanordnung gesteuert werden können, wobei kurze Schaltzeiten bzw. schnelle Taktzeiten bei einer sehr großen Anzahl von Komponenten bzw. Aktuatoren gewährleistet werden. Darüber hinaus soll die Vorrichtung und das Verfahren einfach herstellbar bzw. durchführbar sein und der erforderliche Aufwand niedrig gehalten werden. Ferner sollen die Vorrichtung bzw. das Verfahren gewährleisten, dass Lichtmodulationseinrichtungen, wie Mehrfachspiegelanordnungen mit einer Vielzahl von Komponenten, wie Mikrospiegeln, variabel für unterschiedliche Aufgabenstellungen eingesetzt werden können.

### TECHNISCHE LÖSUNG

Diese Aufgabe wird gelöst durch eine Projektionsbelichtungsanlage mit den Merkmalen des Anspruchs 1 und einem Verfahren mit den Merkmalen des Anspruchs 12 Vorteilhafte Ausgestaltungen sind Gegenstand der abhängigen Ansprüche.

Die Erfindung geht aus von der Erkenntnis, dass die erforderliche Datenmenge, die von einer zentralen oder externen Steuerungseinheit (Controller) an die einzelnen Komponenten einer Lichtmodulationseinrichtung bzw. die Spiegel eines Multi Mirror Arrays oder deren Aktuatoren übertragen werden muss, dann reduziert werden kann, wenn die entsprechenden Parameter zur Positionierung der Aktuatoren in mindestens einem Speicherelement abgelegt sind, so dass die entsprechende Betätigung bzw. Positionierung des Aktuators durch Abrufen des Speicherwerts aus dem Speicher erfolgen kann. Durch eine lokale Anordnung des Speichers in der Nähe des oder der Aktuatoren kann ein weiterer unnötiger Datentransport vermieden werden.

Statt also entsprechende Steuersignale von einer zentralen Steuereinheit an die Vielzahl von Aktuatoren zu übermitteln, wird durch Speicherung entsprechender Parameter für die Betätigung der Aktuatoren und damit Positionierung bzw. Ausrichtung der damit verbundenen Lichtmodulationskomponenten, wie beispielsweise Mikrospiegel, vermieden, dass eine große Datenmenge von einer zentralen Steuerungseinheit zu der Vielzahl von Aktuatoren transportiert werden muss. Hierbei kann je nach Bedarf und Anforderung entweder jedem einzelnen Aktuator ein eigenes Speicherelement mit verschiedenen Speicherplätzen für mindestens zwei Parameter, die jeweils einer Stellung des Aktuators entsprechen, zugeordnet werden oder es können statt eines Speicherelements auch mehrere Speicherelemente für jeden einzelnen Aktuator vorgesehen sein, wobei in diesem Fall pro Speicherelement entweder ein Parameter entsprechend einer Stellung des Aktuators oder wiederum mehrere Parameter gespeichert sein können. Insbesondere ist es dadurch möglich, eine Vielzahl von Stellungen eines Aktuators voreingestellt in entsprechenden Speicherelementen zu hinterlegen, so dass zwischen diesen einzelnen Stellungen des Aktuators schnell und in einfacher Weise hin und her geschaltet werden kann. Statt eines oder mehrer Speicherelement mit jeweils einem oder mehreren Speicherplätzen für jeweils einen Parameter vorzusehen, können auch Gruppen von Aktuatoren gebildet werden, denen jeweils wiederum ein oder mehrere Speicherelemente mit jeweils ein oder mehreren Speicherplätzen für entsprechende Parameter zugeordnet sein können. Entsprechend können die Aktuatoren auch gruppenweise angesteuert werden, wobei es jedoch bevorzugt ist, jeden Aktuator einzeln ansteuern zu können. Die Aktuatoren gemäß der vorliegenden Erfindung werden als eine erste Menge an Aktuatoren einer Projektionsbelichtungsanlage oder einer entsprechenden Vorrichtung angesehen, während andere Aktuatoren als eine zweite Menge an Aktuatoren, die nicht die Merkmale der vorliegenden Erfindung aufweisen, zusätzlich vorhanden sein können.

Vorzugsweise sind die Parameter, die abgelegt sind, durch die Stellsignale für die Aktuatoren gebildet, so dass die gespeicherten Daten nach dem Auslesen aus dem Speicherelement direkt zur Steuerung des jeweiligen Aktuators genutzt werden können ohne zeitaufwändigen Operationen zu unterliegen. Beispielsweise kann lediglich eine Umwandlung digitaler Daten in analoge Steuersignale erforderlich sein. Damit wird wiederum eine schnelle Betätigung der Aktuatoren und der damit betriebenen Lichtmodulationskomponenten ermöglicht.

Die Parameter können, falls beispielsweise zwei Aktuatoren zur Betätigung einer Lichtmodulationskomponente, wie beispielsweise eines Mikrospiegels vorgesehen sind, aus den beiden Stellsignalen für die beiden Aktuatoren bestehen. Sofern beispielsweise für eine Drehung bzw. für eine Schwenkung eines Mikrospiegels um zwei unabhängige Drehachsen vier Aktuatoren vorgesehen sind, kann ein Parameter entsprechend vier Stellsignale für die vier Aktuatoren umfassen. Entsprechend können diese vier Aktuatoren zu einer Gruppe zusammengefasst sein, der ein Speicherelement ausgelesen und zugeordnet ist. Die erfindungsgemäße Vorrichtung umfasst weiterhin eine Steuerungseinheit (Controller), welche z.B. steuert, welche Parameter aus den Speicherelementen eingesetzt werden. Allerdings ist die erforderliche Datenmenge deutlich reduziert.

Die Steuerungseinheit der Lichtmodulationseinrichtung bzw. der Vorrichtung zur Steuerung einer Vielzahl von Aktuatoren, beispielsweise zur Betätigung von Mikrospiegeln einer Mehrfachspiegelanordnung, kann eine Vielzahl von Untersteuerungseinheiten aufweisen, die von der übergeordneten Steuerungseinheit koordiniert werden, aber die Steuerung des einzelnen oder der mehreren ihnen zugeordneten Aktuatoren selbstständig oder eigenständig übernehmen. Insbesondere für den Fall, dass die Steuerungseinheit und/oder Untersteuerungseinheiten als Regelungseinheiten ausgebildet sind, können die Untersteuerungseinheiten eine selbständige Regelung der Aktuatorenstellung übernehmen, so dass dadurch der notwendige Datentransport weiter reduziert wird. Sofern die Steuerungseinheit und/oder die Untersteuerungseinheiten als Regelungseinheiten ausgebildet sind, weist die Vorrichtung entsprechende Messeinrichtungen oder Sensoren auf, um die nötigen Eingangsgrößen für den Regelkreis zu erfassen. Die Verwirklichung der Steuerungseinheit und/oder Untersteuerungseinheiten als Regelungseinheiten kann in jeder bekannten Form, z.B. als PID-Regler erfolgen.

Die Steuerungseinheit kann einen integrierten Schaltkreis und insbesondere einem anwendungsspezifischen integrierten Schaltkreis ASIC (Application Specific Integrated Circuit) aufweisen, welcher die Speicherelmenete umfassen kann und/oder die entsprechenden elektronischen Bauteile aufweist, mittels der einzelne, mehrere oder alle Aktuatoren mit entsprechenden Steuer- bzw. Stelllsignalen versorgt werden.

Die Speicherelemente können entsprechend unmittelbar in dem integrierten Schaltkreis bzw. dem ASIC integriert sein, so dass eine unmittelbare Ansteuerung der Aktuatoren möglich ist. In diesem Fall können die Parameter die Stellsignale aufweisen und nach dem Auslesen unmittelbar - eventuell lediglich über einen Analog-Digital-Wandler - dem Aktuator zur Betätigung zur Verfügung gestellt werden.

Die Speicherelemente können vorzugsweise durch nicht flüchtige Speicherelemente gebildet sein, die also den Speicherinhalt auch bewahren, sofern keine Energieversorgung zur Verfügung steht. Dies ist besonders vorteilhaft, wenn die entsprechende Vorrichtung kurzfristig abgeschaltet werden muss oder eine kurzfristige Unterbrechung der Stromversorgung auftritt.

Als Speicherelemente können RAM-, SRAM-, DRAM-, SDRAM-, ROM-, EPROM-, EEPROM- und FLASH-Speicherelemente sowie alle anderen geeigneten Speicherbausteine eingesetzt werden.

Die Aktuatoren können durch eine MEMS (Micro-Electro-Mechanical-System)-Einheit gebildet sein, welche durch lithographische Prozesse hergestellt werden kann. So ist es möglich, die Aktuatoren beispielsweise zusammen mit den Komponenten der Lichtmodulationseinrichtung, wie beispielsweise den Mikrospiegeln, in einer Einheit auf einem Wafer herzustellen. Auf einer gegenüberliegenden Seite desselben Wafers kann ein entsprechender Schaltkreis der Steuerungseinheit, vorzugsweise ein ASIC, vorgesehen sein. Eine derartige Ausbildung bezeichnet man als 1-Wafer-System. Darüber hinaus sind auch 2-Wafer-Systeme möglich, bei denen auf einem Wafer eine MEMS-Einheit, z.B. mit Aktuatoren und Komponenten einer Lichtmodulationseinrichtung, vorgesehen sind, während auf einem zweiten Wafer ein entsprechender integrierter Schaltkreis der Steuerungseinheit angeordnet ist. Die beiden Wafer sind funktionell miteinander verbunden, so dass die Aktuatoren über den ASIC angesteuert werden können. Entsprechend können auch 3-Wafer-, 4-Wafer- oder Mehr-Wafer-Systeme realisiert werden, bei denen eine entsprechende Anzahl von Wafern mit unterschiedlichen Komponenten zu einer funktionellen Einheit zusammengefasst sind.

Durch die erfindungsgemäße Struktur der Vorrichtung mit einer Speicherung von Parametern für die Schaltung von Aktuatoren ist es möglich, in einfacher Weise zwischen zwei Schaltzuständen des Aktuators hin und her zu schalten, ohne dass von der zentralen Steuerungseinheit eine Vielzahl von Steuerungsdaten übermittelt werden müssten. Es sind lediglich die Parameter für den entsprechenden Aktuator, vorzugweise in Form entsprechender Stellsignale aus den Speicherelementen auszulesen und an den Aktuator zu übermitteln, wobei dies insbesondere durch eine lokale Anordnung von Speicherelementen in der Nähe der Aktuatoren in sehr einfacher Weise erfolgen kann. Neben der dadurch erzielbaren schnellen Schaltung der Aktuatoren ist es durch Speicherung von mindestens zwei Stellungsparametern darüber hinaus möglich einen besonders variablen Einsatz einer entsprechenden Vorrichtung und insbesondere einer Lichtmodulationseinrichtung mit entsprechend betätigbaren Komponenten, wie Mikrospiegeln, zu erzielen. So kann auf einen der Speicherplätze ein neuer Parameter für die Betätigung bzw. Positionierung des Aktuators geladen werden, während der Aktuator gemäß dem Parameter auf einem anderen Speicherplatz betätigt bzw. betrieben wird. Da für die Vielzahl von Speicherelementen, die den jeweiligen Aktuatoren zugeordnet sind, die entsprechenden Speicherplätze nach und nach geladen bzw. geändert werden können, können die entsprechenden Parameter für zukünftige Schaltprozesse mit einer niedrigen Datenflussrate bereits während des Betriebs geladen werden. Dies macht einen besonders variablen Einsatz möglich.

Insbesondere kann sich dieser Ladevorgang über einen längeren Zeitraum, beispielsweise bei einem taktweisen Betrieb der Vorrichtung über mehrere Takte erstrecken.

Der entsprechende zyklusartige, rollende Ladevorgang neuer bzw. geänderter Speicherdaten von Speicherelement zu Speicherelement bzw. Speicherplatz zu Speicherplatz kann entsprechend wiederholt durchgeführt werden, so dass ohne Unterbrechung des Betriebs eine Vielzahl unterschiedlichster Stellungen der Aktuatoren nach einander eingestellt werden können. Entsprechend kann beispielsweise eine Lithographieanlage bzw. eine Projektionsbelichtungsanlage mit einer erfindungsgemäßen Vorrichtung für zukünftige Belichtungsvorgänge individuell eingestellt werden, so dass letztendlich individuelle Einzelbelichtungen möglich werden.

### KURZBESCHREIBUNG DER FIGUREN

Weitere Vorteile, Kennzeichen und Merkmale der vorliegenden Erfindung werden bei der nachfolgenden detaillierten Beschreibung von Ausführungsbeispielen anhand der beigefügten Zeichnungen deutlich. Die Zeichnungen zeigen hierbei in rein schematischer Weise in
Fig. 1 ein maskenloses Lithographiesystem mit einer erfindungsgemäßen Vorrichtung;
Fig. 2 eine Projektionsbelichtungsanlage mit einer Lichtmodulationseinrichtung im Beleuchtungssystem eines Retikels;
Fig. 3 eine Seitenansicht einer erfindungsgemäßen Vorrichtung in einer 1-Wafer-Ausführung;
Fig. 4 eine Seitenansicht einer erfindungsgemäßen Vorrichtung in einer 2-Wafer-Ausführung;
Fig. 5 eine perspektivische Ansicht einer erfindungsgemäßen Vorrichtung in einer 4-Wafer-Ausführung; und in
Fig. 6 eine Seitenansicht der Ausführungsform der Figur 5.

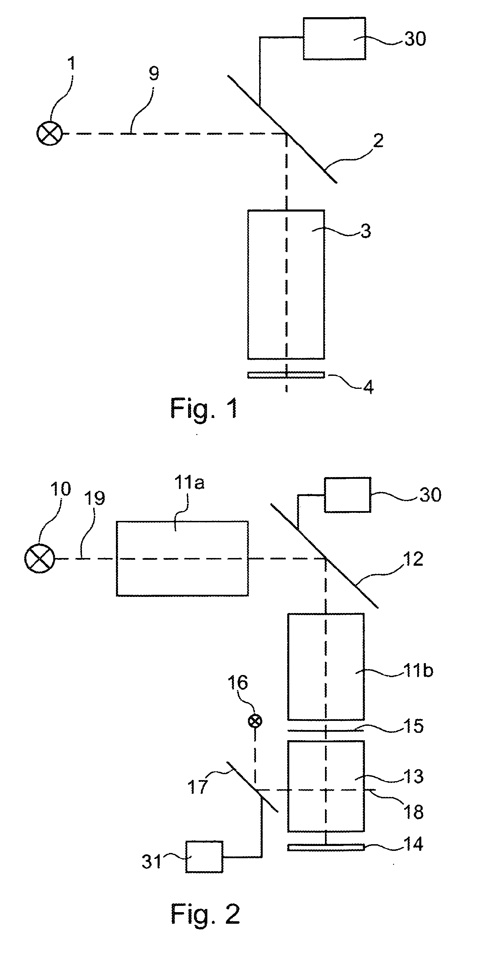

Fig. 1 zeigt ein erstes, rein schematisches Beispiel eines Lithographiesystems, bei welchem das Licht oder allgemein die Strahlung eine Lichtquelle bzw. Strahlungsquelle 1 entlang einer optischen Achse 9 auf eine Lichtmodulationseinrichtung in Form einer Mehrfachspiegelanordnung 2 (Multi-Mirror-Array, MMA) fällt, welches eine Struktur oder ein Muster erzeugt, das über ein Projektionsobjektiv 3 auf einen Wafer 4 oder allgemein Substrat mit einer strahlungsempfindlichen Schicht abgebildet wird.

Die Mehrfachspiegelanordnung 2 weist eine Vielzahl von Mikrospiegeln auf, die über eine Steuerungseinheit 30 angesteuert werden, um ihre Ausrichtung und Position über Aktuatoren einzustellen. Durch eine Veränderung der Stellung bzw. Position der Mikrospiegel der Mehrfachspiegelanordnung 2 können unterschiedliche Muster erzeugt und durch das Projektionsobjektiv 3 auf den Wafer 4 abgebildet werden.

Eine weitere Anwendung in einem Lithographiesystem zeigt die Fig. 2, in welchem eine Projektionsbelichtungsanlage gezeigt ist, bei welcher das Licht bzw. allgemein die Strahlung einer Strahlungs- bzw. Lichtquelle 10 über eine Beleuchtungsanlage 11a, 11b, 12 auf ein Retikel 15 gelenkt wird, dessen Struktur über das Projektionsobjektiv 13 wiederum auf einen Wafer 14 abgebildet wird.

Die Beleuchtungsanordnung umfasst entlang der optischen Achse 19 zwei Beleuchtungsoptiken 11a und 11b, zwischen denen wiederum eine Lichtmodulationseinrichtung, beispielsweise wiederum in Form einer Mehrfachspiegelanordnung (MMA) 12 vorgesehen ist. Die Mehrfachspiegelanordnung 12 wird in diesem Ausführungsbeispiel dazu verwendet, in einer Pupillenebene der Beleuchtungsanordnung 11a, 11b, 12 eine variabel einstellbare Intensitätsverteilung der Strahlung zu erzeugen. Auch hier wird die Mehrfachspiegelanordnung 12 über eine Steuerungseinheit 30 derart gesteuert, dass die Mikrospiegel der Mehrfachspiegelanordnung durch entsprechende Ausrichtung und Positionierung zu der gewünschten Intensitätsverteilung der Strahlung in der Pupillenebene beitragen.

In der Ausführungsform der Figur 2 ist eine dritte Anwendung einer Lichtmodulationseinrichtung, wiederum in Form einer Mehrfachspiegelanordnung 17 gezeigt, bei der Licht bzw. Strahlung einer Hilfslicht- bzw. Strahlungsquelle entsprechend der optischen Achse 18 auf ein optisches Element des Projektionsobjektiv 13 geleitet wird, um beispielsweise durch die Hilfsstrahlung strahlungsinduzierte Abbildungsfehler, beispielsweise aufgrund einer ungleichmäßigen Strahlungsverteilung über dem entsprechenden optischen Element des Projektionsobjektivs 13 zu kompensieren. Eine derartige Anwendung ist beispielsweise in der deutschen Patentanmeldung DE 10 2008 016 011 offenbart. Die beiden anderen Anwendungsfälle von Lichtmodulationseinrichtungen, die in den Figuren 1 und 2 beschrieben sind, sind beispielsweise in der DE 103 43 333 sowie der EP 914626 bzw. WO 98/04950 beschrieben.

Die Lichtmodulationseinrichtung 17 in Form einer Mehrfachspiegelanordnung wird ebenfalls über eine Steuerungseinheit 31 gesteuert, die die Position der Mikrospiegel gemäß den Anforderungen des einzustrahlenden Korrekturlichts festlegt.

Sowohl die Steuerungseinheit 30 als auch die Steuerungseinheit 31 können als Regelungseinrichtungen ausgeführt sein, bei welchen in Abhängigkeit von Messwerten, beispielsweise von Sensoren oder dergleichen, die Sollpositionen der Mikrospiegel in Abhängigkeit der gemessenen Positionen entsprechend bekannten regelungstechnischer Maßnahmen geregelt werden. Entsprechend können Messvorrichtungen bzw. Sensoren oder dergleichen (nicht gezeigt) zusätzlich vorgesehen sein.

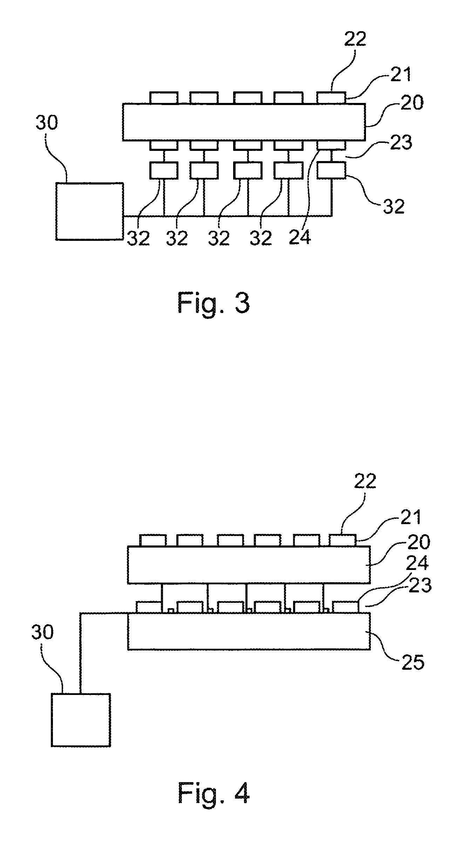

Die Figuren 3 und 4 zeigen in schematischen Seitenansichten zwei Ausführungsformen erfindungsgemäßer Vorrichtungen, die bei den Lithographiesystemen bzw. Projektionsbelichtungsanlagen in Fig. 1 bzw. Fig. 2 eingesetzt werden können. Darüber hinaus können entsprechende Vorrichtungen auch bei zusätzlichen Manipulatoren, die in Abbildungsvorrichtungen vorgesehen werden können, wie beispielsweise Manipulatoren für die Ausrichtung von optischen Elementen, wie Linsen und dergleichen, eingesetzt werden, wobei dies insbesondere dann vorteilhaft ist, wenn eine Vielzahl von Manipulatoren gesteuert oder geregelt werden müssen.

Die Fig. 3 zeigt eine erfindungsgemäße Vorrichtung in einer so genannten 1-Wafer-Ausführung, bei welcher die Aktuatoren 21 und die Mikrospiegel 22 in der so genannten MEMS (Micro Electro-Mechanical System)-Technologie hergestellt worden sind. Bei dieser Technologie werden die mechanischen und/oder elektromechanischen Komponenten ähnlich den elektronischen Bauteilen eines integrierten Schaltkreises durch lithographische Strukturierung erzeugt, so dass sich der Vorteil ergibt, dass mechanische und/oder elektronische wie auch elektromechanische Komponenten in einfacher Weise auf ein und demselben Wafer 20 erzeugt werden können. Entsprechend können die Mikrospiegel 22 und die Aktuatoren 21 in dem MEMS-System der Figur 3 unmittelbar auf demselben Wafer 20, beispielsweise einem Silicium-Substrat ausgebildet werden, wie ein anwendungsspezifischer integrierter Schaltkreis (ASIC Application Specific Integrated Circuit) 23, welcher auf der gegenüberliegenden Seite des Wafers 20 vorgesehen ist. Durch den Wafer 20 hindurch oder über die entsprechenden Stirnseiten ist eine funktionsfähige Verbindung des ASIC 23 mit dem MEMS-Bauteilen 21, 22 gegeben.

Erfindungsgemäß enthält der ASIC 23 eine Vielzahl von Speicherelementen 24, von denen jeweils eines einem Aktuator 21 zugeordnet ist. Jedes Speicherelement 24 weist mindestens zwei Speicherplätze für Parameter auf, die Positionen bzw. Ausrichtungen der Mikrospiegel 22 entsprechen. Vorzugsweise umfasst ein Parameter die Stellsignale für den oder die Aktuatoren 21 eines Mikrospiegels 22 der Mehrfachspiegelanordnung, so dass beim Auslesen eines Parameters unmittelbar die Stellsignale an die Aktuatoren 21 übermittelt werden können. Entsprechend sind sehr kurze Schaltzeiten der Mikrospiegel 22 realisierbar.

Die verwendeten Speicherelemente 24 sind vorzugsweise nicht flüchtige Speicherelemente. Dies bedeutet, dass für die Beibehaltung des Speicherzustandes, also die Beibehaltung der gespeicherten Information, keine andauernde Energieversorgung erforderlich ist. Vielmehr behalten die Speicherelemente auch bei Abschaltung oder Energieunterbrechung, zumindest für eine bestimmte Zeit, ihre Speicherinformation.

Mit dem ASIC 23 sind Untersteuerungseinheiten 32 verbunden, die wiederum mit einer übergeordneten Steuerungseinheit 30 z.B. über einen Datenbus verbunden sind. Alle zusammen bilden die Steuerung der Mehrfachspiegelanordnung. Die Untersteuerungseinheiten können für jeden Aktuator separat oder für Gruppen von Aktuatoren 21 vorgesehen sein. Die Steuerungseinheit 30 und/oder die Untersteuerungseinheiten 32 können auch in dem ASIC 23 integriert sein.

Das Auslesen der Speicherelemente 24 mit den entsprechenden Parametern erfolgt durch die Steuerungseinheit 30 bzw. den einzelnen Mikrospiegeln bzw. Aktuatoren zugeordneten Untersteuerungseinheiten 32. Beispielsweise kann die zentrale Steuerungseinheit 30 über ein Bus-System an die Untersteuerungseinheiten 32 den Befehl zur Ausrichtung der einzelnen Mikrospiegel 22 übermitteln, woraufhin die Untersteuerungseinheiten 32, die entsprechend vorab in den Speicherelementen 24 gespeicherten Stellsignale auswählt und durch unmittelbare Bereitstellung aus dem Speicher 24 für die Aktuatoren 21 eine sehr schnelle Schaltung der Spiegel 22 ermöglicht. Durch die lokale Speicherung der Parameter für die Stellung der einzelnen Spiegel wird eine Übermittlung einer Vielzahl von Daten von der zentralen Steuerungseinheit 30 an die Untersteuerungseinheiten 32 vermieden und/oder die Bearbeitung in den Untersteuerungseinheiten 32 reduziert.

Insbesondere kann auch auf die Untersteuerungseinheiten 32 ganz verzichtet werden. Dies ist beispielsweise in der Ausführungsform der Fig. 4 verwirklicht, ist aber auch für die Ausführungsform der Fig. 3 möglich. Die Fig. 4 zeigt eine zweite Ausführungsform der erfindungsgemäßen Vorrichtung. Die Vorrichtung der Fig. 4 ist bis auf einige Unterschiede, die nachfolgend näher erläutert werden, mit der Ausführungsform der Fig. 3 identisch, so dass für identische Komponenten identische Bezugszeichen Verwendung finden.

Die Ausführungsform der Fig. 4 unterscheidet sich von derjenigen der Fig. 3 im Wesentlichen dadurch, dass anstelle einer 1-Wafer-Ausführung eine 2-Wafer-Ausführung verwirklicht ist. Hierbei entspricht der Wafer 20 einer Mehrfachspiegelanordnung mit einer Vielzahl von Mikrospiegeln 22, die durch eine Vielzahl von den Mikrospiegeln zugeordneten Aktuatoren betätigt werden können. Im Gegensatz zur Ausführungsform der Fig. 3 ist jedoch der anwendungsspezifischen integrierte Schaltkreis ASIC 23 nicht auf dem Wafer 20 vorgesehen, sondern auf einem zweiten separaten Wafer 25, der beispielsweise ebenfalls aus Silizium gebildet sein kann. Die beiden Wafer 20 und 25 werden dann in bekannter Weise direkt miteinander verbunden, um eine entsprechende Wirkverbindung herzustellen. Dies kann beispielsweise durch direktes Bonden oder Kleben erfolgen.

Der ASIC 23 der Ausführungsform der Fig. 4 entspricht im Wesentlichen dem ASIC 23 der Ausführungsform der Fig. 3, allerdings mit dem Unterschied, dass die Steuerungseinheit 30 keine Untersteuerungseinheiten 32 aufweist, sondern die Befehle direkt an die Speicherelemente 24 von der zentralen Steuerungseinheit 30 gesendet werden.

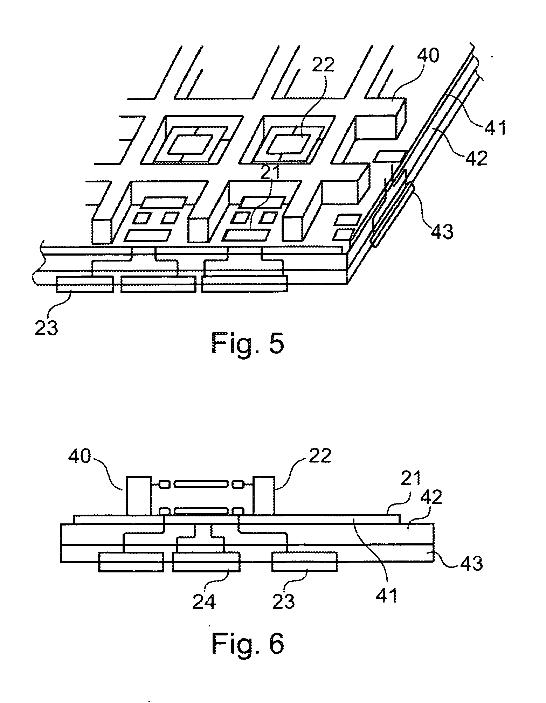

Die Figuren 5 und 6 zeigen in einer perspektivischen Darstellung und in einer Seitenansicht eine 4-Wafer-Ausführung einer erfindungsgemäßen Vorrichtung. Bei den Wafern 40 bis 43 kann es sich um separate Wafer, z.B. Silizium-Substrate handeln oder um Schichten von gemeinsamen Wafern.

Wie in den Figuren 5 und 6 zu sehen ist, umfasst die erste Schicht bzw. der erste Wafer 40 die Mikrospiegel 22, während in der darunter angeordneten Schicht bzw. dem darunter angeordneten Wafer 41 die Aktuatoren z.B. in Form von Elektroden zur Betätigung der Spiegel vorgesehen sind. Die dritte Schicht bzw. der dritte Wafer 42 umfasst eine sogenannte Verkabelungs- bzw. Routing- oder Wiring-Layer, bei der die entsprechenden Verbindungen zwischen den Aktuatoren der Aktuatorenschicht bzw. des Aktuatorenwafers 41 und des darunter angeordneten ASIC-Wafers bzw. der entsprechenden ASIC-Schicht 43 vorgesehen sind.

Im ASIC-Layer bzw. dem ASIC-Wafer 43 ist der integrierte Schaltkreis bzw. die entsprechende Elektronik 23 mit Speicherelementen 24 vorgesehen.

Die Spiegleschicht bzw. der Spiegelwafer 40 kann noch weiter untergliedert werden in eine Unterschicht, welche die eigentlichen Mikrospiegel 22 enthält und einer zweiten Unterschicht, die die Spiegellagerung mit entsprechenden Gelenkstrukturen umfasst.

In genau der gleichen Art und Weise kann die dritte Funktionsebene in form des Verkabelungswafers 42 in mehrere Unterschichten untergliedert werden, um die zum Teil sehr komplexe Leitungsführung zu ermöglichen. Entsprechend kann der Aufbau auch insgesamt mehrschichtig oder über mehrere Wafer erfolgen.

Durch das Vorsehen bzw. Zuordnen von Speicherelementen 24 mit vorab abgespeicherten Parametern für die Einstellung der Aktuatoren bzw. der von ihnen betätigten Komponenten der Lichtmodulationseinrichtung ist es nicht nur möglich, sehr schnelle Schaltzeiten der Komponenten der Lichtmodulationseinrichtung, beispielsweise der Mikrospiegel 22 einer Mehrfachspiegelanordnung zu gewährleisten, sondern es ist auch ein variabler Einsatz der Lichtmodulationseinrichtung möglich, da während des Betriebs fortlaufend eine Änderung der gespeicherten Parameter vorgenommen werden kann. So kann beispielsweise bei mindestens zwei gespeicherten Parametern für jeweils einen Aktuator oder eine Aktuatorgruppe der gerade nicht genutzte Parameter durch einen anderen ersetzt werden, der in Zukunft, beispielsweise in einem nächsten Schritt eingesetzt werden soll.

Obwohl die vorliegende Erfindung in den gezeigten Ausführungsbeispiele dahingehend beschrieben worden ist, dass für jede Komponente einer Lichtmodulationseinrichtung, wie beispielsweise einen Mikrospiegel einer Mehrfachspiegelanordnung ein Aktuator vorgesehen ist, können selbstverständlich auch mehrere Aktuatoren für eine Komponente einer Lichtmodulationseinrichtung, wie beispielsweise einen Mikrospiegel einer Mehrfachspiegelanordnung vorgesehen sein. Diesen mehrfachen Aktuatoren einer entsprechenden Lichtmodulationskomponente können jeweils einzelne Speicherelemente zugeordnet sein oder ein gemeinsames Speicherelement für die Gruppe von mehreren Aktuatoren.

Obwohl die vorliegende Erfindung anhand der Ausführungsbeispiele für Mehrfachspiegelanordnungen in MEMS-Technologie beschrieben ist, ist selbstverständlich, dass die Erfindung auch auf andere Lichtmodulationseinrichtungen bzw. mikromechanische bzw. elektromechanische Komponenten anwendbar ist, die in herkömmlicher Mikrotechnologie hergestellt sind.

Obwohl die vorliegende Erfindung anhand der beigefügten Ausführungsbeispiele detailliert beschrieben ist, ist für den Fachmann selbstverständlich, dass Abwandlungen oder Modifikationen durch unterschiedliche Kombination einzelner Merkmale oder Weglassen einzelner Merkmale möglich sind. Der Schutzbereich der Ansprüche ist nicht auf die Ausführungsbeispiele beschränkt, sondern wird durch die beigefügten Ansprüche definiert.

Folgende Beispiele stellen keine Ausführungsformen der Erfindung dar:
1. Projektionsbelichtungsanlage für die Mikrolithographie mit einer Vorrichtung für die Steuerung einer Vielzahl von Aktuatoren (21) mit einer Steuerungseinheit (30, 31) und einer Vielzahl durch die Steuerungseinheit steuerbarer Aktuatoren (21), wobei zumindest mehrere Gruppen von Aktuatoren einzeln durch die Steuerungseinheit ansteuerbar sind,
   dadurch gekennzeichnet, dass
   jedem Aktuator oder jeder Gruppe von Aktuatoren einer ersten Menge von Aktuatoren mindestens ein Speicherelement (24) zugeordnet ist, welches mindestens einen Parameter zur Ansteuerung eines oder mehrerer Aktuatoren speichern kann, so dass jedem Aktuator oder jeder Gruppe von Aktuatoren mindestens zwei Parameter zugeordnet sind, wobei jedem der Parameter eine Stellung des oder der Aktuatoren zugeordnet ist.
2. Projektionsbelichtungsanlage nach Beispiel 1,
   dadurch gekennzeichnet, dass
   zusätzlich kein oder mindestens ein Aktuator einer zweiten Menge von Aktuatoren in der Projektionsbelichtungsanlage angeordnet ist, die sich von den Aktuatoren der ersten Menge unterscheiden.
3. Projektionsbelichtungsanlage nach Beispiel 1,
   dadurch gekennzeichnet, dass
   jeder Aktuator (21) einzeln über die Steuerungseinheit (30, 31) ansteuerbar ist.
4. Projektionsbelichtungsanlage nach einer der vorhergehenden Beispiele,
   dadurch gekennzeichnet, dass
   jedem Aktuator oder jeder Gruppe von Aktuatoren der ersten Menge von Aktuatoren mindestens ein Speicherelement (24) zugeordnet ist, welches mindestens zwei Parameter zur Ansteuerung des Aktuators speichern kann, wobei jedem der Parameter eine Stellung des oder der Aktuatoren zugeordnet ist.
5. Projektionsbelichtungsanlage nach einer der vorhergehenden Beispiele,
   dadurch gekennzeichnet, dass
   zwei oder mehr Speicherelemente für jeden Aktuator oder jede Gruppe von Aktuatoren (21) der ersten Menge von Aktuatoren vorgesehen sind, die ein oder mehr Parameter zur Ansteuerung des oder der Aktuatoren speichern können, wobei jedem der Parameter eine Stellung des oder der Aktuatoren zugeordnet ist.
6. Projektionsbelichtungsanlage nach einer der vorhergehenden Beispiele,
   dadurch gekennzeichnet, dass
   die gespeicherten Parameter Stellsignale für die Aktuatoren (21) der ersten Menge von Aktuatoren sind.
7. Projektionsbelichtungsanlage nach einer der vorhergehenden Beispiele,
   dadurch gekennzeichnet, dass
   die gespeicherten Parameter Stellsignale für ein oder mehrere Bewegungsfreiheitsgrade der Aktuatoren der ersten Menge von Aktuatoren umfassen.
8. Projektionsbelichtungsanlage nach einer der vorhergehenden Beispiele,
   dadurch gekennzeichnet, dass
   die Steuerungseinheit (30, 31) eine Vielzahl von Untersteuerungseinheiten (32) umfasst, die insbesondere in ihrer Anzahl der Anzahl der Aktuatoren oder Gruppen von Aktuatoren der ersten Menge von Aktuatoren entsprechen.
9. Projektionsbelichtungsanlage nach einer der vorhergehenden Beispiele,
   dadurch gekennzeichnet, dass
   die Steuerungseinheit (30, 31) und/oder die Untersteuerungseinheiten (32) als Regelungseinheiten ausgebildet sind.
10. Projektionsbelichtungsanlage nach einer der vorhergehenden Beispiele,
   dadurch gekennzeichnet, dass
   die Steuerungseinheit (30) einen integrierten Schaltkreis oder anwendungsspezifischen, integrierten Schaltkreis ASIC (23) umfasst oder durch einen von diesen gebildet ist, der einzelne, mehrere oder alle Aktuatoren mit Stellsignalen versorgt.
11. Projektionsbelichtungsanlage nach einer der vorhergehenden Beispiele,
   dadurch gekennzeichnet, dass
   die Speicherelemente (24) Teil eines integrierten Schaltkreises oder eines anwendungsspezifischen, integrierten Schaltkreises (23) sind.
12. Projektionsbelichtungsanlage nach einer der vorhergehenden Beispiele,
   dadurch gekennzeichnet, dass
   die in den Speicherelementen gespeicherten Parameter unmittelbar zur Ansteuerung der Aktuatoren (21) der ersten Menge von Aktuatoren bereit stehen.
13. Projektionsbelichtungsanlage nach einer der vorhergehenden Beispiele,
   dadurch gekennzeichnet, dass
   die Speicherelemente (24) durch nicht flüchtige Speicherelemente gebildet sind.
14. Projektionsbelichtungsanlage nach einer der vorhergehenden Beispiele,
   dadurch gekennzeichnet, dass
   die Speicherelemente (24) ausgewählt sind aus der Gruppe, die RAM-, SRAM-, DRAM-, SDRAM-, ROM, EPROM-, EEPROM und FLASH-Speicherelemente umfasst.
15. Projektionsbelichtungsanlage nach einer der vorhergehenden Beispiele,
   dadurch gekennzeichnet, dass
   die Aktuatoren (21) der ersten Menge von Aktuatoren durch eine MEMS (micro electromechanical system) - Einheit gebildet sind.
16. Projektionsbelichtungsanlage nach einer der vorhergehenden Beispiele,
   dadurch gekennzeichnet, dass
   die Vorrichtung ein 1-Wafer-System, ein 2-Wafer-System, ein 3-Wafer-System, ein 4-Wafer-System oder ein Mehr-Wafer-System umfasst.
17. Projektionsbelichtungsanlage nach einer der vorhergehenden Beispiele,
   dadurch gekennzeichnet, dass
   die Aktuatoren Teil eines Manipulationssystems für eine Vorrichtung aus einer Gruppe sind, die eine Abbildungsvorrichtung, eine Projektionsbelichtungsanlage für die Mikrolithographie, Lichtmodulatoren, räumliche Lichtmodulatoren (SLM spatial light modulator), und Mehrfachspiegelanordnungen (MMA multi mirror arrays) (2, 12, 17) umfasst.
18. Projektionsbelichtungsanlage nach einer der vorhergehenden Beispiele,
   dadurch gekennzeichnet, dass
   die Aktuatoren (21) in entsprechender Anzahl zur Positionierung von Spiegelelementen (22) vorgesehen sind.
19. Projektionsbelichtungsanlage nach einer der vorhergehenden Beispiele,
   dadurch gekennzeichnet, dass
   die Aktuatoren (21) in entsprechender Anzahl für die Positionierung von bis zu 6 Millionen oder von bis zu 4 Millionen oder von 4000 bis 1000000 Spiegeln (22) vorgesehen sind, welche vorzugsweise um jeweils mindestens zwei Drehachsen verschwenkbar sind.
20. Projektionsbelichtungsanlage für die Mikrolithographie nach einer der vorhergehenden Beispiele,
   dadurch gekennzeichnet, dass
   die Vorrichtung in der Beleuchtungsoptik und/oder dem Projektionsobjektiv vorgesehen ist.
21. Verfahren zur Steuerung einer Vielzahl von Aktuatoren (21) in einer Projektionsbelichtungsanlage mit einer Steuerungseinheit (30, 31), vorzugsweise mit einer Vorrichtung nach einer der Ausführungsformen 1 bis 20, wobei zumindest mehrere Gruppen von Aktuatoren einzeln durch die Steuerungseinheit ansteuerbar sind und jedem Aktuator oder jeder Gruppe von Aktuatoren einer ersten Menge von Aktuatoren mindestens ein Speicherelement (24) zugeordnet ist, wobei für jeden Aktuator oder jede Gruppe von Aktuatoren der ersten Menge von Aktuatoren in dem mindestens einen zugeordneten Speicherelement mindestens ein Parameter zur Ansteuerung eines oder mehrerer Aktuatoren der ersten Menge von Aktuatoren gespeichert wird, so dass jedem Aktuator oder jeder Gruppe von Aktuatoren der ersten Menge von Aktuatoren mindestens zwei Parameter zugeordnet werden, wobei jedem der Parameter eine Stellung des oder der Aktuatoren zugeordnet ist.
22. Verfahren nach Beispiel 21,
   dadurch gekennzeichnet, dass
   mindestens zwei Parameter in einem Speicherelement oder jeweils ein oder mehr Parameter in mehreren, einem Aktuator oder einer Gruppe von Aktuatoren der ersten Menge von Aktuatoren zugeordneten Speicherelementen gespeichert werden.
23. Verfahren nach Beispiel 21 oder 22,
   dadurch gekennzeichnet, dass
   zumindest ein Teil der Speicherelemente der Vielzahl von Aktuatoren während des Betriebs der durch die Aktuatoren angetriebenen Elemente mit Parametern versorgt werden.
24. Verfahren nach einer der Beispiele 21 bis 23,
   dadurch gekennzeichnet, dass
   bei einem taktweisen Betrieb der Aktuatoren die Speicherelemente der Aktuatoren über mindestens zwei oder mehr Takte mit Parametern versorgt werden.
25. Verfahren nach einer der Beispiele 21 bis 24,
   dadurch gekennzeichnet, dass
   die einem Aktuator oder einer Gruppe von Aktuatoren der ersten Menge von Aktuatoren zugeordneten Speicherelemente während des Betriebs oder eines Schaltzyklus des oder der Aktuatoren mit einem ersten gespeicherten Parameterwert mit einem zweiten, von dem ersten unterschiedlichen Parameter geladen werden.
26. Verfahren nach einer der Beispiele 21 bis 25,
   dadurch gekennzeichnet, dass
   die Speicherelemente zeitlich nacheinander mit Parametern geladen werden.
27. Verfahren nach einer der Beispiele 21 bis 26,
dadurch gekennzeichnet, dass
die Parameter in einem Zyklus oder wiederkehrenden Zyklus in den Speicherelementen ausgetauscht werden.

## Patentansprüche

1. Projektionsbelichtungsanlage für die Mikrolithographie mit einer Vorrichtung für die Steuerung einer Vielzahl von Aktuatoren (21) mit einer Steuerungseinheit (30, 31) und einer Vielzahl durch die Steuerungseinheit steuerbarer Aktuatoren (21), wobei zumindest mehrere Gruppen von Aktuatoren einzeln durch die Steuerungseinheit ansteuerbar sind,
jedem Aktuator oder jeder Gruppe von Aktuatoren einer ersten Menge von Aktuatoren mindestens ein Speicherelement (24) zugeordnet ist, welches mindestens einen Parameter zur Ansteuerung eines oder mehrerer Aktuatoren speichern kann, so dass jedem Aktuator oder jeder Gruppe von Aktuatoren mindestens zwei Parameter zugeordnet sind, wobei jedem der Parameter eine Stellung des oder der Aktuatoren zugeordnet ist, **dadurch gekennzeichnet, dass** die in den Speicherelementen gespeicherten Parameter unmittelbar zur Ansteuerung der Aktuatoren (21) der ersten Menge von Aktuatoren bereitstehen.

2. Projektionsbelichtungsanlage nach Anspruch 1,
wobei
zusätzlich kein oder mindestens ein Aktuator einer zweiten Menge von Aktuatoren in der Projektionsbelichtungsanlage angeordnet ist, die sich von den Aktuatoren der ersten Menge unterscheiden.

3. Projektionsbelichtungsanlage nach Anspruch 1,
wobei
jeder Aktuator (21) einzeln über die Steuerungseinheit (30, 31) ansteuerbar ist.

4. Projektionsbelichtungsanlage nach einem der vorhergehenden Ansprüche,
wobei
jedem Aktuator oder jeder Gruppe von Aktuatoren der ersten Menge von Aktuatoren mindestens ein Speicherelement (24) zugeordnet ist, welches mindestens zwei Parameter zur Ansteuerung des Aktuators speichern kann, wobei jedem der Parameter eine Stellung des oder der Aktuatoren zugeordnet ist, und/oder zwei oder mehr Speicherelemente für jeden Aktuator oder jede Gruppe von Aktuatoren (21) der ersten Menge von Aktuatoren vorgesehen sind, die ein oder mehr Parameter zur Ansteuerung des oder der Aktuatoren speichern können, wobei jedem der Parameter eine Stellung des oder der Aktuatoren zugeordnet ist.

5. Projektionsbelichtungsanlage nach einem der vorhergehenden Ansprüche,
wobei
die gespeicherten Parameter Stellsignale für die Aktuatoren (21) oder für ein oder mehrere Bewegungsfreiheitsgrade der Aktuatoren der ersten Menge von Aktuatoren umfassen.

6. Projektionsbelichtungsanlage nach einem der vorhergehenden Ansprüche,
wobei
die Steuerungseinheit (30, 31) eine Vielzahl von Untersteuerungseinheiten (32) umfasst, und/oder die die Unterstreuungseinheiten (32) in ihrer Anzahl der Anzahl der Aktuatoren oder Gruppen von Aktuatoren der ersten Menge von Aktuatoren entsprechen und/oder die Steuerungseinheit (30, 31) und/oder die Untersteuerungseinheiten (32) als Regelungseinheiten ausgebildet sind.

7. Projektionsbelichtungsanlage nach einem der vorhergehenden Ansprüche,
wobei
die Steuerungseinheit (30) einen integrierten Schaltkreis oder anwendungsspezifischen, integrierten Schaltkreis ASIC (23) urnfasst oder durch einen von diesen gebildet ist, der einzelne, mehrere oder alle Aktuatoren mit Stellsignalen versorgt und/oder die Speicherelemente (24) umfasst.

8. Projektionsbelichtungsanlage nach einem der vorhergehenden Ansprüche,
wobei
die Aktuatoren (21) der ersten Menge von Aktuatoren durch eine MEMS (micro electromechanical system) - Einheit gebildet sind und/oder die Vorrichtung ein 1-Wafer-System, ein 2-Wafer-System, ein 3-Wafer-System, ein 4-Wafer-System oder ein Mehr-Wafer-System umfasst.

9. Projektionsbelichtungsanlage nach einem der vorhergehenden Ansprüche,
wobei
die Aktuatoren Teil eines Manipulationssystems für eine Vorrichtung aus einer Gruppe sind, die wobei Lichtmodulatoren, räumliche Lichtmodulatoren (SLM spatial light modulator) und Mehrfachspiegelanordnungen (MMA multi mirror arrays) (2, 12, 17) umfasst.

10. Projektionsbelichtungsanlage nach einem der vorhergehenden Ansprüche,
wobei
die Aktuatoren (21) in entsprechender Anzahl für die Positionierung von bis zu 6 Millionen oder von bis zu 4 Millionen oder von 4000 bis 1000000 Spiegeln (22) vorgesehen sind, welche vorzugsweise um jeweils mindestens zwei Drehachsen verschwenkbar sind.

11. Projektionsbelichtungsanlage für die Mikrolithographie nach einem der vorhergehenden Ansprüche,
wobei
die Vorrichtung in der Beleuchtungsoptik und/oder dem Projektionsobjektiv vorgesehen ist.

12. Verfahren zur Steuerung einer Vielzahl von Aktuatoren (21) einer Projektionsbelichtungsanlage mit einer Steuerungseinheit (30, 31), vorzugsweise mit einer Vorrichtung nach einem der Ansprüche 1 bis 11 wobei zumindest mehrere Gruppen von Aktuatoren einzeln durch die Steuerungseinheit ansteuerbar sind und jedem Aktuator oder jeder Gruppe von Aktuatoren einer ersten Menge von Aktuatoren mindestens ein Speicherelement (24) zugeordnet ist, wobei für jeden Aktuator oder jede Gruppe von Aktuatoren der ersten Menge von Aktuatoren in dem mindestens einen zugeordneten Speicherelement mindestens ein Parameter zur Ansteuerung eines oder mehrerer Aktuatoren der ersten Menge von Aktuatoren gespeichert wird, so dass jedem Aktuator oder jeder Gruppe von Aktuatoren der ersten Menge von Aktuatoren mindestens zwei Parameter zugeordnet werden, wobei jedem der Parameter eine Stellung des oder der Aktuatoren zugeordnet ist, **dadurch gekennzeichnet dass** die in den Speicherelementen gespeicherten Parameter unmittelbar zur Ansteuerung der Aktuatoren (21) der ersten Menge von Aktuatoren bereitstehen.

13. Verfahren nach Anspruch 12,
wobei
mindestens zwei Parameter in einem Speicherelement oder jeweils ein oder mehr Parameter in mehreren, einem Aktuator oder einer Gruppe von Aktuatoren der ersten Menge von Aktuatoren zugeordneten Speicherelementen gespeichert werden

14. Verfahren nach Anspruch 12 oder 13,
wobei
zumindest ein Teil der Speicherelemente der Vielzahl von Aktuatoren während des Betriebs der durch die Aktuatoren angetriebenen Elemente mit Parametern versorgt werden und/oder bei einem taktweisen Betrieb der Aktuatoren die Speicherelemente der Aktuatoren über mindestens zwei oder mehr Takte mit Parametern versorgt werden.

15. Verfahren nach einem der Ansprüche 12 bis 14,
wobei
die einem Aktuator oder einer Gruppe von Aktuatoren der ersten Menge von Aktuatoren zugeordneten Speicherelemente während des Betriebs oder eines Schaltzyklus des oder der Aktuatoren mit einem ersten gespeicherten Parameterwert mit einem zweiten, von dem ersten unterschiedlichen Parameter geladen werden.

16. Verfahren nach einem der Ansprüche 12 bis 15,
wobei
die Speicherelemente zeitlich nacheinander mit Parametern geladen werden und/oder die Parameter in einem Zyklus oder wiederkehrenden Zyklus in den Speicherelementen ausgetauscht werden.

## Claims

1. Projection exposure system for micro-lithography with a device for controlling a plurality of actuators (21) with a controller (30, 31) and a plurality of actuators (21) controllable by the controller, wherein at least several groups of actuators may be controlled individually by the controller, wherein to each actuator or each group of actuators of a first quantity of actuators is assigned at least one memory element (24), which can store at least one parameter for controlling one or more actuators, such that at least two parameters are assigned to each actuator or each group of actuators, with one position of the actuator(s) being assigned to each of the parameters.
**characterised by** the fact that
the parameters stored in the memory elements are directly available for controlling the actuators (21) of the first quantity of actuators.

2. Projection exposure system in accordance with claim 1, **wherein**
in the projection exposure system is additionally arranged no or at least one actuator of a second quantity of actuators which differ from the actuators of the first quantity.

3. Projection exposure system in accordance with claim 1,
**wherein**
each actuator (21) is individually controllable via the controller (30, 31).

4. Projection exposure system in accordance with any of the previous claims,
**wherein**
to each actuator or each group of actuators of the first quantity of actuators is assigned at least one memory element (24), which can store at least two parameters for controlling the actuator, wherein to each of the parameters is assigned a position of the actuator(s), and/or two or more memory elements are provided for each actuator or each group of actuators (21) of the first quantity of actuators that can store one or more parameters for controlling the actuator(s), wherein to each of the parameters is assigned a position of the actuator(s).

5. Projection exposure system in accordance with any of the previous claims,
**wherein**
the stored parameters comprise control signals for the actuators (21) or for one or more degrees of movement freedom of the actuators of the first quantity of actuators.

6. Projection exposure system in accordance with any of the previous claims,
**wherein**
the controller (30, 3 1) comprises a plurality of sub-controllers (32), and/or the sub-controllers (32) correspond in their number to the number of actuators or groups of actuators of the first quantity of actuators and/or the controller (30, 31) and/or the sub-controllers (32) are formed as regulating units.

7. Projection exposure system in accordance with any of the previous claims,
**wherein**
the controller (30) comprises an integrated circuit or application specific integrated circuit ASIC (23) or is formed by one of these, which supplies individual, several or all actuators with control signals and/or the memory elements (24).

8. Projection exposure system in accordance with any of the previous claims,
**wherein**
the actuators (21) of the first quantity of actuators are formed by a MEMS (micro electromechnical system) unit and/or the device comprises a 1-wafer system, a 2-wafer system, a 3-wafer system, a 4-wafer system or a multi-wafer system.

9. Projection exposure system in accordance with any of the previous claims,
**wherein**
the actuators are part of a manipulation system for a device from a group that comprises light modulators, spatial light modulators (SLMs), and multi-mirror arrays (MMAs) (2, 12, 17).

10. Projection exposure system in accordance with any of the previous claims,
**wherein**
the actuators (21) are provided in corresponding number for positioning up to 6 million, or up to 4 million, or 4000 to 1000000 mirrors (22), which can preferably pivot about two rotational axes each at least.

11. Projection exposure system for micro-lithography in accordance with any of the previous claims,
**wherein**
the device is provided in the illumination optics and/or the projection objective.

12. Method for controlling a plurality of actuators (21) of a projection exposure system with a controller (30,31), preferably with a device in accordance with any of claims 1 to 11, wherein at least several groups of actuators may be controlled individually by the controller and to each actuator or each group of actuators of a first quantity of actuators is assigned at least one memory element (24), wherein, for each actuator or each group of actuators of the first quantity of actuators at least one parameter for controlling one or more actuators of the first quantity of actuators is stored in the at least one assigned memory element, such that to each actuator or each group of actuators of the first quantity of actuators are assigned at least two parameters, wherein one position of the actuator(s) is assigned to each of the parameters,
**characterised by** the fact that
the parameters stored in the memory elements are directly available for controlling the actuators (21) of the first quantity of actuators.

13. Method in accordance with claim 12,
**wherein**
at least two parameters are stored in a memory element or one or more parameters each are stored in several memory elements assigned to an actuator or a group of actuators of the first quantity of actuators.

14. Method in accordance with claim 12 or 13,
**wherein**
at least a part of the memory elements of the plurality of actuators are supplied with parameters during operation of the elements driven by the actuators and/or, in the case of cyclic operation of the actuators, the memory elements of the actuators are supplied with parameters for at least two or more cycles.

15. Method in accordance with any of claims 12 to 14,
**wherein**
the memory elements assigned to an actuator or a group of actuators of the first quantity of actuators are, during operation or a switching cycle of the actuator(s) with a first stored parameter value, loaded with a second parameter different from the first.

16. Method in accordance with any of claims 12 to 15,
**wherein**
the memory elements are loaded successively in time with parameters and/or the parameters are swapped in a cycle or a repeating cycle in the memory elements.

## Revendications

1. Installation d'exposition par projection pour la microlithographie avec un dispositif pour la commande d'une pluralité d'actuateurs (21) avec une unité de commande (30, 31) et une pluralité d'actuateurs (21) qui peuvent être commandés par l'unité de commande, au moins plusieurs groupes d'actuateurs pouvant être excités individuellement par l'unité de commande,
au moins un élément de mémoire (24) étant associé à chaque actuateur ou à chaque groupe d'actuateurs d'une première quantité d'actuateurs, élément qui peut mémoriser au moins un paramètre pour exciter un ou plusieurs actuateurs si bien qu'au moins deux paramètres sont associés à chaque actuateur ou à chaque groupe d'actuateurs, une position de l'actuateur ou des actuateurs étant associée à chacun des paramètres,
**caractérisée en ce que**
les paramètres mémorisés dans les éléments de mémoire sont mis à disposition directement pour exciter les actuateurs (21) de la première quantité d'actuateurs.

2. Installation d'exposition par projection selon la revendication 1,
de plus aucun ou au moins un actuateur d'une seconde quantité d'actuateurs qui se distinguent des actuateurs de la première quantité étant placé dans l'installation d'exposition par projection.

3. Installation d'exposition par projection selon la revendication 1,
chaque actuateur (21) pouvant être excité individuellement par l'unité de commande (30, 31).

4. Installation d'exposition par projection selon l'une des revendications précédentes,
au moins un élément de mémoire (24) étant associé à chaque actuateur ou à chaque groupe d'actuateurs de la première quantité d'actuateurs, élément de mémoire qui peut mémoriser au moins deux paramètres pour exciter l'actuateur, une position de l'actuateur ou des actuateurs étant associée à chacun des paramètres et/ou deux éléments de mémoire ou plus étant prévus pour chaque actuateur ou pour chaque groupe d'actuateurs (21) de la première quantité d'actuateurs, éléments de mémoire qui peuvent mémoriser un ou plusieurs paramètres pour exciter l'actuateur ou les actuateurs, une position de l'actuateur ou des actuateurs étant associée à chacun des paramètres.

5. Installation d'exposition par projection selon l'une des revendications précédentes,
les paramètres mémorisés comprenant des signaux de réglage pour les actuateurs (21) ou pour un ou plusieurs degrés de liberté de mouvement des actuateurs de la première quantité d'actuateurs.

6. Installation d'exposition par projection selon l'une des revendications précédentes,
l'unité de commande (30, 31) comprenant une pluralité d'unités de sous-commande (32) et/ou le nombre des unités de sous-commande (32) correspondant au nombre des actuateurs ou des groupes d'actuateurs de la première quantité d'actuateurs et/ou l'unité de commande (30, 31) et/ou les unités de sous-commande (32) étant configurées comme des unités de réglage.

7. Installation d'exposition par projection selon l'une des revendications précédentes,
l'unité de commande (30) comprenant un circuit intégré ou un circuit intégré propre à une application ASIC (23) ou étant formée par l'un de ceux-ci, circuit qui alimente plusieurs ou tous les actuateurs avec des signaux de réglage et/ou qui comprend les éléments de mémoire (24).

8. Installation d'exposition par projection selon l'une des revendications précédentes,
les actuateurs (21) de la première quantité d'actuateurs étant formés par une unité MEMS (système microélectromécanique) et/ou le dispositif comprenant un système à 1 wafer, un système à 2 wafers, un système à 3 wafers, un système à 4 wafers ou un système multi-wafers.

9. Installation d'exposition par projection selon l'une des revendications précédentes,
les actuateurs étant partie d'un système de manipulation pour un dispositif d'un groupe qui comprend les modulateurs de lumière, les modulateurs spatiaux de lumière (SLM spatial light modulator) et les réseaux de micro-miroirs (MMA multi mirror arrays) (2, 12, 17).

10. Installation d'exposition par projection selon l'une des revendications précédentes,
les actuateurs (21) étant prévus en nombre correspondant pour le positionnement de jusqu'à six millions ou jusqu'à quatre millions ou de 4000 à 1000000 miroirs (22) qui peuvent être, de préférence, pivotés respectivement autour d'au moins deux axes de rotation.

11. Installation d'exposition par projection pour la microlithographie selon l'une des revendications précédentes,
le dispositif étant prévu dans l'optique d'éclairage et/ou l'objectif de projection.

12. Procédé pour la commande d'une pluralité d'actuateurs (21) d'une installation d'exposition par projection avec une unité de commande (30, 31), de préférence avec un dispositif selon l'une des revendications 1 à 11, au moins plusieurs groupes d'actuateurs pouvant être excités individuellement par l'unité de commande et au moins un élément de mémoire (24) étant associé à chaque actuateur ou à chaque groupe d'actuateurs d'une première quantité d'actuateurs, au moins un paramètre pour l'excitation d'un ou de plusieurs actuateurs de la première quantité d'actuateurs étant mémorisé pour chaque actuateur ou chaque groupe d'actuateurs de la première quantité d'actuateurs dans l'élément de mémoire associé qui existe au moins si bien qu'au moins deux paramètres sont associés à chaque actuateur ou à chaque groupe d'actuateurs de la première quantité d'actuateurs, une position de l'actuateur ou des actuateurs étant associée à chacun des paramètres, **caractérisé en ce que** les paramètres mémorisés dans les éléments de mémoire sont mis à disposition directement pour l'excitation des actuateurs (21) de la première quantité d'actuateurs.

13. Procédé selon la revendication 12,
au moins deux paramètres étant mémorisés dans un élément de mémoire ou respectivement un ou plusieurs paramètres étant mémorises dans plusieurs éléments de mémoire associés à un actuateur ou à un groupe d'actuateurs de la première quantité d'actuateurs.

14. Procédé selon la revendication 12 ou 13,
au moins une partie des éléments de mémoire de la pluralité d'actuateurs étant alimentée en paramètres pendant le fonctionnement des éléments entraînés par les actuateurs et/ou, lors d'un fonctionnement cadencé, les éléments de mémoire des actuateurs étant alimentés en paramètres pendant au moins deux cadences ou plus.

15. Procédé selon l'une des revendications 12 à 14,
les éléments de mémoire associés à un actuateur ou à un groupe d'actuateurs de la première quantité d'actuateurs étant chargés, pendant le fonctionnement ou pendant un cycle de commutation de l'actuateur ou des actuateurs, avec une première valeur de paramètre mémorisée avec un second paramètre différent du premier paramètre.

16. Procédé selon l'une des revendications 12 à 15,
les éléments de mémoire étant chargés l'un après l'autre dans le temps avec des paramètres et/ou les paramètres étant remplacés dans les éléments de mémoire dans un cycle ou dans un cycle répétitif.
